# DEMANDE DE BREVET EUROPEEN

(11) **EP 4 170 435 A1**
(43) Date de publication de la demande: **26.04.2023**
(21) Numéro de dépôt: 21204426.7
(22) Date de dépôt: 25.10.2021
(51) Int. Cl.: G04D 3/00

(54) **PROCEDE DE FABRICATION D'UNE PIECE D'HABILLAGE, NOTAMMENT UNE PIECE D'HABILLAGE D'UNE PIECE D HORLOGERIE**

(71) Demandeur: Comadur S.A., 2400 Le Locle (CH)
(72) Inventeur: LINTYMER, Jan, 25000 Mamirolle (FR); BOULMAY, Alexis, 25500 Morteau (FR)
(74) Mandataire: ICB SA

(57) **Abrégé**

L'invention concerne un procédé de fabrication d'une pièce d'habillage (10) comprenant une représentation graphique décorative, comportant les étapes de :
- dépôt 200 d'un revêtement (20) opaque ou partiellement transparent sur une face d'un substrat (30) transparent ou partiellement transparent, ladite face étant destinée à recevoir un rayonnement lumineux incident ou transmis,
- structuration 300 dudit revêtement (20) de sorte à réaliser des orifices (21) traversants dans ledit revêtement (20) selon une densité de répartition telle que lesdits orifices (21) forment la représentation graphique décorative.

## Description

### Domaine technique de l'invention

L'invention relève du domaine des composants d'habillage d'articles de mode, et concerne un procédé de fabrication d'une pièce d'habillage notamment destinée à une pièce d'horlogerie.

Avantageusement, la présente invention peut être appliquée à une pièce de bijouterie ou à un article de lunetterie.

Une telle pièce d'habillage peut être un cadran, un compteur de cadran, une lunette, une glace, etc.

### Arrière-plan technologique

Les pièces d'habillage dans le domaine de l'horlogerie sont destinées à jouer un rôle décoratif important.

Pour générer un aspect esthétique souhaité d'une pièce d'habillage, on connait un grand nombre de méthodes.

Par exemple, il est connu de déposer successivement des couches de couleurs différentes et de les structurer au fur et à mesure de ces dépôts successifs, de sorte à obtenir un décor avec une pluralité de couleurs.

Toutefois, il peut être complexe d'assurer un alignement des structurations des différentes couches, et par conséquent, il est possible que deux couches sensées être accolées se chevauchent en partie ou, au contraire, soient séparées par un espace non souhaité.

La présente invention a pour objectif de résoudre notamment ce problème de défaut d'alignement de structurations de couches d'un revêtement d'un substrat.

### Résumé de l'invention

L'invention résout les inconvénients précités en proposant une solution permettant d'obtenir sur une pièce d'habillage un décor pouvant présenter des couleurs variées, tout en garantissant le respect des exigences dimensionnelles dudit décor.

A cet effet, la présente invention concerne un procédé de fabrication d'une pièce d'habillage comprenant une représentation graphique décorative, comportant les étapes de :
- dépôt 200 d'un revêtement opaque ou partiellement transparent sur une face d'un substrat transparent ou partiellement transparent, ladite face étant destinée à recevoir un rayonnement lumineux incident ou transmis,
- structuration 300 dudit revêtement de sorte à réaliser des orifices traversants dans ledit revêtement selon une densité de répartition telle que ledit revêtement forme la représentation graphique décorative.

Ainsi, le procédé ne possédant qu'une unique étape de structuration, les exigences dimensionnelles pour réaliser la représentation graphique décorative sont plus aisées à respecter.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de mise en œuvre, l'étape de structuration 300 est réalisée de sorte que les orifices forment des motifs présentant respectivement des densités de répartition qui leur sont propres. Dans des modes particuliers de mise en œuvre, lors d'une étape préliminaire 100, le substrat est poli.

Dans des modes particuliers de mise en œuvre, l'étape de dépôt 200 est réalisée par méthode de dépôt sous vide.

L'étape de dépôt 200 peut être réalisée en plusieurs opérations de dépôt sous vide, si le revêtement est composé de plusieurs couches.

Dans des modes particuliers de mise en œuvre, le revêtement présente un niveau de transparence moins important que le niveau de transparence du substrat.

Dans des modes particuliers de mise en œuvre, l'étape de structuration 300 est réalisée par photolithographie ou par structuration directe par laser.

Dans des modes particuliers de mise en œuvre, l'étape de dépôt 200 consiste à déposer une unique couche.

Dans d'autres modes particuliers de mise en œuvre, l'étape de dépôt 200 consiste à déposer plusieurs couches successivement. L'étape de dépôt 200 comporte alors les opérations de dépôts successifs, par exemple de trois couches dont :
- une couche d'accroché est déposée directement contre le substrat,
- une couche fonctionnelle est déposée sur la couche d'accroché, et
- une couche de protection est déposée sur la couche fonctionnelle.

Dans des modes particuliers de mise en œuvre, la couche d'accroche est réalisée en chrome, en titane, en zircone, ou en oxynitrures de ces matériaux, la couche fonctionnelle est réalisée en or ou en argent, et la couche de protection est réalisée en chrome, en titane ou en zircone, ou en oxynitrure de ces matériaux.

Dans des modes particuliers de mise en œuvre, le substrat est réalisé en verre, en saphir ou en nacre.

Dans des modes particuliers de mise en œuvre, lors de l'étape de structuration, des orifices sont réalisés de sorte à présenter des dimensions telles qu'ils soient sensiblement invisibles à l'œil nu.

Dans des modes particuliers de mise en œuvre, lors de l'étape de structuration 300, des orifices sont réalisés de sorte que leur section droite présente une forme circulaire dont le diamètre est inférieur à 50 micromètres.

Dans des modes particuliers de mise en œuvre, lors de l'étape de structuration 300, des orifices sont réalisés de sorte que leur section droite présente une forme polygonale, dont les dimensions sont comprises entre 5 et 50 micromètres en largeur, et 5 et 500 micromètres en longueur.

Selon un autre objet, la présente invention concerne une pièce d'horlogerie comprenant une pièce d'habillage réalisée par la mise en œuvre d'un procédé tel que décrit précédemment, dans laquelle la pièce d'habillage forme un cadran ou une glace.

### Brève description des figures

D'autres caractéristiques et avantages de l'invention apparaîtront à la lecture de la description détaillée suivante donnée à titre d'exemple nullement limitatif, en référence aux dessins annexés dans lesquels :
- la figure 1 représente un logigramme d'un procédé de fabrication d'une pièce d'habillage comportant une représentation graphique décorative selon un exemple de mise en œuvre de la présente invention ;
- la figure 2 représente une vue en coupe transversale d'un exemple de réalisation de la pièce d'habillage obtenue par la mise en œuvre du procédé de la figure 1 ;
- la figure 3 représente une vue de face d'un autre exemple de réalisation de la pièce d'habillage obtenue par la mise en œuvre du procédé de la figure 1, ladite pièce d'habillage comprenant un revêtement présentant différentes densités de répartition et différentes formes d'orifices traversants.
Il y a lieu de noter que les figures ne sont pas à l'échelle.

### Description détaillée de l'invention

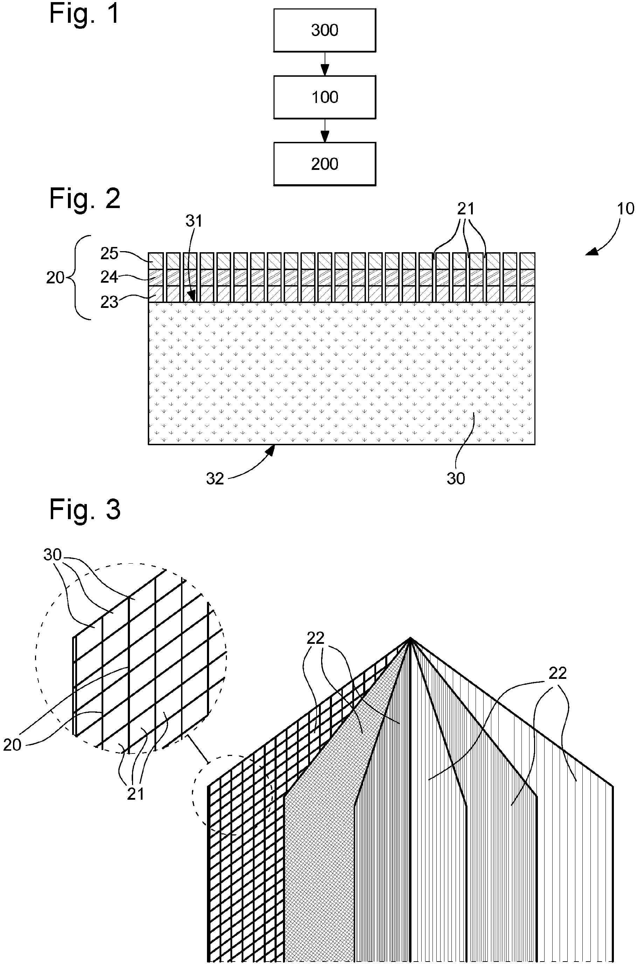

La figure 1 montre un logigramme représentant les étapes d'un procédé de fabrication d'une pièce d'habillage 10 comportant une représentation graphique décorative selon la présente invention.

Une telle représentation graphique peut être un logo, une image décorative, une inscription, etc.

La pièce d'habillage 10 est représentée en vue de coupe transversale sur la figure 2 et en vue de face sur la figure 3.

Dans un exemple d'application préférée, la pièce d'habillage 10 peut être une glace, un cadran, un compteur de cadran, une lunette, etc. pour une pièce d'horlogerie, notamment une montre.

La pièce d'habillage 10 comporte un revêtement 20 s'étendant sur tout ou partie de la surface d'une face d'un substrat 30 transparent ou partiellement transparent, ladite face étant destinée à recevoir un rayonnement lumineux incident ou transmis.

Le revêtement 20 est déposé lors d'une étape de dépôt 200.

Le terme « partiellement transparent » désigne, dans le présent texte, une capacité d'un élément à être translucide. Cette capacité est obtenue par la nature du matériau constituant l'élément et/ou par l'épaisseur dudit élément.

A titre d'exemple préférentiel, le substrat 30 est réalisé en saphir, en verre ou en nacre, ou en tout autre matériau pouvant présenter une transparence élevée ou suffisante pour la réalisation de la présente invention, et des caractéristiques mécaniques appropriées. Naturellement, l'homme du métier sait appliquer le matériau adéquat selon l'application de la pièce d'habillage, par exemple le substrat peut être réalisé en verre ou en saphir si la pièce d'habillage 10 forme une glace, ou le substrat put être réalisé en nacre si la pièce d'habillage 10 forme un cadran.

Avantageusement, le substrat 30 peut être coloré, soit avant l'étape de dépôt 200, soit après l'étape de structuration 300.

Le substrat 30 peut avantageusement être poli lors d'une étape préliminaire 100 réalisée avant l'étape de dépôt 200 de revêtement 20, afin de réduire les aspérités et la rugosité à sa surface. Autrement dit, cette étape préliminaire 100 permet d'obtenir un état lisse et brillant des surfaces du substrat 30.

De façon alternative, sans la réalisation de l'étape préliminaire 100, le substrat présente un aspect mat.

Avantageusement, le substrat 30 étant transparent ou partiellement transparent, le revêtement 20 peut être agencé sur la surface d'une face externe 32 ou d'une face interne 31 du substrat 30.

Dans l'exemple d'application préféré, la face interne 31 du substrat 30 est destinée à être agencée en regard d'un mouvement horloger et la face externe 32 est destinée à être agencée en regard d'un environnement externe ; notamment en regard d'un utilisateur. Il y a lieu de noter que dans cette application, le substrat 30 présente une fonction structurelle dans la mesure où son épaisseur est choisie de sorte qu'il présente une rigidité suffisante pour maintenir la pièce d'habillage 10 en position et résister aux contraintes mécaniques.

Le revêtement 20 peut être partiellement transparent, c'est-à-dire translucide, ou opaque, étant entendu qu'il absorbe préférentiellement davantage la lumière que ne le fait le substrat. En d'autres termes, le revêtement 20 présente une transparence moins importante que le substrat.

La transparence peut notamment être définie par un test de transmission lumineuse d'un rayonnement lumineux d'une longueur d'onde donnée au travers d'une plaque de matériau. Un tel test est à la portée de l'homme du métier. La transparence est exprimée en pourcentage de transmission. Par exemple, le revêtement 20 peut être configuré de sorte à présenter un pourcentage de transmission inférieur à 60% et le substrat 30 peut être configuré de sorte à présenter un pourcentage de transmission supérieur à 60%. Le niveau de transparence désiré est obtenu par le choix du matériau et/ou de l'épaisseur de l'élément considéré, notamment respectivement du revêtement 20 et du substrat 30.

Avantageusement, le revêtement 20 peut être réalisé partiellement ou totalement en matériau métallique.

L'étape de dépôt 200 peut être avantageusement réalisée par une méthode de dépôt sous vide, par exemple de dépôt physique en phase vapeur ou par une méthode de dépôt chimique en phase vapeur. Cette étape de dépôt 200 peut être réalisée en une opération, si le revêtement est composé d'une unique couche, ou en plusieurs opérations si le revêtement 20 est composé de plusieurs couches, comme décrit ci-après.

Le revêtement 20 comporte une pluralité d'orifices 21 traversants réalisés lors d'une étape de structuration 300 selon une densité de répartition telle que le revêtement 20 forme la représentation graphique décorative.

Ces orifices 21 étant traversants, ils laissent apparaître le substrat 30, de sorte que ce dernier soit soumis au rayonnement lumineux.

Les orifices 21 présentent par exemple des dimensions telles qu'ils puissent sensiblement être invisibles à l'œil nu, le pouvoir de résolution de l'œil humain étant de l'ordre de 70 micromètres à une distance de 25 centimètres.

Les dimensions font ici référence au diamètre des orifices 21 s'ils présentent une section droite de forme circulaire, ou à la longueur et à la largeur s'ils présentent une section droite de forme polygonale.

Dans l'exemple de réalisation de la présente invention représenté sur la figure 3, les orifices présentent des sections droites de forme polygonale.

Les dimensions des orifices peuvent varier entre quelques micromètres et quelques dizaines micromètres en largeur, par exemple entre 5 et 50 micromètres, et varier entre quelques micromètres et quelques centaines de micromètres en longueur, par exemple entre 5 et 500 micromètres. Les orifices peuvent par ailleurs s'étendre selon des formes allongées sur plus de 500 micromètres de longueur et présenter une largeur de quelques micromètres ou dizaines de micromètres.

Alternativement, les orifices 21 peuvent présenter une section droite de forme circulaire dont le diamètre est inférieur à 50 micromètres.

Ainsi, le rayonnement lumineux peut circuler à travers les orifices 21 et le substrat 30, au sein duquel un phénomène optique de diffraction est généré.

L'étape de structuration 300 est réalisée par usinage laser, par usinage chimique, par photolithographie, par structuration directe par laser, ou par tout autre méthode d'enlèvement de matière appropriée.

Avantageusement, l'étape de structuration 300 est réalisée de sorte que la répartition des orifices 21 formés, ainsi que leurs dimensions respectives, sont choisis de sorte que le revêtement 20 matérialise la représentation graphique décorative. En particulier, la densité de répartition des orifices 21 est définie selon la représentation graphique que l'on cherche à reproduire.

Avantageusement, le revêtement 20 peut comporter plusieurs zones comprenant chacune une densité de répartition d'orifices 21 différente des autres, chaque zone formant un motif 22, comme le montre la figure 3. Autrement dit, l'étape de dépôt 200 peut être réalisée de sorte à former le revêtement 20 sur une partie de la surface du substrat 30 définissant la surface des motifs 22 et l'étape de structuration 300 peut être réalisée de sorte à générer localement des densités de répartition des orifices 21 différentes à la surface de la pièce d'habillage 10.

Par ailleurs, les orifices 21 d'un ou de plusieurs motifs 22 peuvent présenter des formes identiques à celle des orifices 21 des autres motifs 22, ou alternativement, les orifices 21 d'un motif 22 peuvent présenter des formes différentes de celles des orifices 21 d'un ou de plusieurs motifs 22. En outre, au sein d'un même motif 22, les orifices 21 peuvent présenter des sections droites de forme identiques ou différentes, suivant la représentation graphique à matérialiser.

Les possibilités de répartition des orifices 21 sont très nombreuses. A titre d'exemple, les orifices 21 peuvent être répartis de façon homogène ou de façon hétérogène au sein des motifs 22. En particulier, au sein d'un même motif 22, les orifices 21 peuvent être agencés de façon à ce que leur densité de répartition évolue progressivement d'une extrémité à l'autre du motif 22, de sorte à créer la représentation graphique souhaitée.

Préférentiellement, l'étape de structuration 300 est réalisée uniquement dans le revêtement 20, c'est-à-dire sans impacter le substrat 30.

Un des avantages de la présente invention réside dans le fait que, le substrat 30 étant transparent ou partiellement transparent et le revêtement 20 partiellement transparent ou opaque, la structuration du revêtement 20 génère un effet optique conférant à la pièce d'habillage 10 un aspect « mat » c'est-à-dire diminue la réflexion et la brillance globale de la couche dans ces zones.

Par ailleurs, la présente invention permet de représenter des variations d'une couleur de la pièce d'habillage 10, par exemple des nuances, selon la densité de répartition des orifices 21. Plus particulièrement, plus la répartition des orifices 21 est dense, plus la couleur du substrat 30 est visible, à l'inverse de celle du revêtement 20, et moins la répartition des orifices 21 est dense, plus la couleur du revêtement 20 est visible, à l'inverse de celle du substrat 30.

Dans un exemple préféré de réalisation de l'invention, tel que représenté sur la figure 2, le revêtement 20 peut comporter trois couches, parmi lesquelles une couche d'accroché 23 déposée directement sur le substrat 30, une couche fonctionnelle 24 déposée sur la couche d'accroché 23, et une couche de protection 25 déposée sur la couche fonctionnelle 24.

A titre d'exemple, la couche d'accroché 23 peut être réalisée en chrome, en titane ou en zircone, ou en mélange de métaux ou de leurs oxynitrures ; la couche fonctionnelle 24 peut être réalisée en or, en argent, ou en un autre métal précieux ; la couche de protection 25 peut être réalisée en chrome, en titane, en zircone ou en mélange de métaux ou en oxynitrures de ces matériaux.

Autrement dit, les couches d'accroché 23 et de protection 25 peuvent être réalisées en oxynitrures de métaux, du type MOxNy, la composition en oxygène et en azote étant variable et pouvant être nulle.

Dans ce cas, les couches d'accroché 23, fonctionnelle 24 et de protection 25 du revêtement 20 sont successivement déposées sur le substrat 30 lors de l'étape de dépôt 200, puis l'étape de structuration 300 est réalisée.

Cet exemple de réalisation du revêtement 20 comprenant une pluralité de couches est préféré lorsque le revêtement 20 est réalisé à partir de métaux précieux.

Le revêtement 20 pourrait alternativement être constitué uniquement par la couche fonctionnelle 24.

## Revendications

1. Procédé de fabrication d'une pièce d'habillage (10) comprenant une représentation graphique décorative, **caractérisé en ce qu'**il comporte les étapes de :
- dépôt 200 d'un revêtement (20) opaque ou partiellement transparent sur une face d'un substrat (30) transparent ou partiellement transparent, ladite face étant destinée à recevoir un rayonnement lumineux incident ou transmis,
- structuration 300 dudit revêtement (20) de sorte à réaliser des orifices (21) traversants dans ledit revêtement (20) selon une densité de répartition telle que lesdits orifices (21) forment la représentation graphique décorative.

2. Procédé selon la revendication 1, dans lequel l'étape de structuration 300 est réalisée de sorte que les orifices (21) forment des motifs (22) présentant respectivement des densités de répartition qui leur sont propres.

3. Procédé selon la revendication 1 ou 2, dans lequel lors d'une étape préliminaire 100, le substrat (30) est poli.

4. Procédé selon l'une des revendications 1 à 3, dans lequel l'étape de dépôt 200 est réalisée par méthode de dépôt sous vide.

5. Procédé selon l'une des revendications 1 à 4, dans lequel le revêtement (20) présente un niveau de transparence moins important que le niveau de transparence du substrat (30).

6. Procédé selon l'une des revendications 1 à 5, dans lequel l'étape de structuration 300 est réalisée par photolithographie ou par structuration directe par laser.

7. Procédé selon l'une des revendications 1 à 6, dans lequel l'étape de dépôt 200 comporte les opérations de dépôts successifs de trois couches (23, 24, 25) dont :
- une couche d'accroché (23) est déposée directement contre le substrat,
- une couche fonctionnelle (24) est déposée sur la couche d'accroché, et
- une couche de protection (25) est déposée sur la couche fonctionnelle.

8. Procédé selon la revendication 7, dans lequel la couche d'accroché (23) est réalisée en chrome, en titane ou en zircone, la couche fonctionnelle (24) est réalisée en or ou en argent, et la couche de protection (25) est réalisée en chrome, en titane, ou en zircone ou en oxynitrure de ces matériaux.

9. Procédé selon l'une des revendications 1 à 8, dans lequel le substrat (30) est réalisé en verre, en saphir ou en nacre.

10. Procédé selon l'une des revendications 1 à 9, dans lequel lors de l'étape de structuration 300, des orifices (21) sont réalisés de sorte à présenter des dimensions telles qu'ils soient sensiblement invisibles à l'œil nu.

11. Procédé selon la revendication 10, dans lequel lors de l'étape de structuration 300, des orifices sont réalisés de sorte que leur section droite présente une forme circulaire dont le diamètre est inférieur à 50 micromètres.

12. Procédé selon l'une des revendications 10 ou 11, dans lequel l'étape de structuration 300, des orifices sont réalisés de sorte que leur section droite présente une forme polygonale, dont les dimensions sont comprises entre 5 et 50 micromètres en largeur, et 5 et 500 micromètres en longueur.

13. Pièce d'horlogerie comprenant une pièce d'habillage (10) réalisée par la mise en œuvre d'un procédé selon l'une des revendications 1 à 12, dans laquelle la pièce d'habillage (10) forme un cadran, une lunette ou une glace.
